# EUROPEAN PATENT APPLICATION

(11) **EP 0 655 714 A1**
(43) Date of publication of application: **31.05.1995**
(21) Application number: 94308762.7
(22) Date of filing: 28.11.1994
(51) Int. Cl.: G06T 15/10

(54) **Transformation of digital terrain elevation data to reveal areas of low observability**

(30) Priority: 30.11.1993 US 159651; 18.01.1994 US 182891; 18.01.1994 US 182894
(71) Applicant: HONEYWELL INC., Minneapolis Minnesota 55408 (US)
(72) Inventor: Iwerks, James M., Rio Rancho, New Mexico 87124 (US); Lippitt, Carl E., Albuquerque, New Mexico 87111 (US)
(74) Representative: Fox-Male, Nicholas Vincent Humbert

(57) **Abstract**

A method of observability characterization for data posts in a digital terrain elevation data structure is obtained by calculating intervisibility with respect to surrounding data posts within a given radius. By then summing the number of data posts within this radius and visible to the data post of interest, an observability value may then be associated with the data post of interest. This observability value represents observability generally with respect to surrounding terrain as a whole, not with respect to a specific other point in the database. In this manner, terrain may be evaluated for observability generally in, for example, route selection procedures where observability plays a role.

## Description

### BACKGROUND OF THE INVENTION

The present invention relates generally to use of digital terrain elevation data (DTED), and particularly to use of a transformation function applied to digital terrain elevation data to reveal terrain masked areas of low observability.

Digital terrain elevation data represents surface altitude at discrete "data posts." Each data post has a surface location or address, e.g., latitude and longitude, and an associated altitude, e.g., vertical offset relative to sea level. Thus, a simple form of a DTED database would deliver a scaler altitude in response to longitude and latitude input. More complicated DTED databases have been developed for certain applications. For example, U.S. Patent No. 4,899,292 issued February 6, 1990 to J. F. Dawson and E. W. Ronish shows a tessellation method for creating a spherical database by warping a digital map, including digital terrain elevation data, by longitude and latitude parameters.

DTED database systems are used in flight mission computer systems and flight planning strategy in military applications to aid in, for example, covert and evasive flight operations. As used in mission computer systems, a DTED database can aid a pilot in time-critical maneuvers such as in selecting evasive routes with respect to a given threat position. Threat positions may be known in advance and included in the DTED database, or detected while in flight. The computation and speed required in accessing and calculating routes or alternatives based on DTED database systems can be vitally critical, especially for computations executed repeatedly to keep a pilot fully appraised of current terrain conditions and route alternatives. Thus, improvements in methods of accessing DTED database systems and computations based on extracted DTED are not simply improvements in computational elegance, but can be life-saving and critical to mission success.

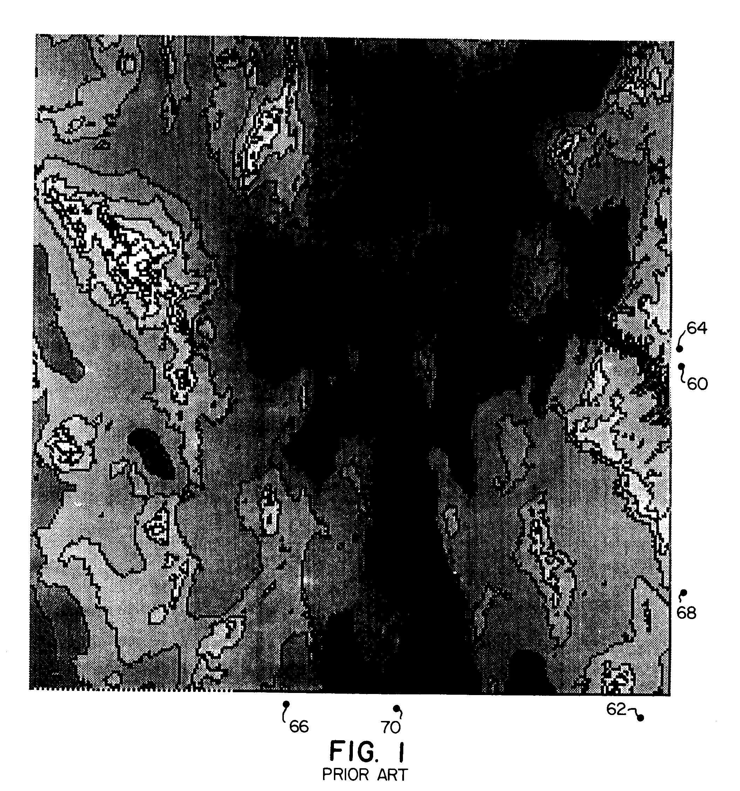

A DTED database may be used in flight planning for low altitude covert air routes. Such routes should be well obscured by surrounding terrain, i.e., terrain masked. A DTED database used to determine local minimums of terrain altitude, with the assumption that local minimums of terrain altitude correspond to local minimums in observability, could provide an observability function. FIG. 1 is a computer generated topographic map illustrating such prior use of a terrain elevation map wherein darker areas are associated with relatively low elevation and lighter colored areas are associated with relatively higher elevation. Thus, this topographic mapping provides color gradation making obvious local minimums in terrain elevation. Generally, route selection algorithms look for the lowest elevation path and assume that staying in the bottom of valleys provides low observability. Unfortunately, the correlation between local minimums of terrain altitude and observability of a local minimum from other points near the earth's surface is weak. More particularly, when flying along a valley floor an aircraft is quite visible from many points within the valley. If the aircraft travels along the center of a wide valley, the aircraft is generally visible throughout the entire valley. Furthermore, route planning algorithms applied to DTED database systems are typically automated by computer without aid of intelligent human decision making. Thus, such automated route planning algorithms may make certain mistakes in attempting to seek-out lower terrain flight paths as a basis for low observability. For example, a high elevation valley desirably providing low observability for a flight path therealong, may not be selected under such automated flight planning algorithms when a much lower elevation valley is nearby. Accordingly, use of terrain elevation maps in the manner depicted in FIG. 1 do not provide the desired indication of regions having low observability with respect to surrounding terrain especially when implemented in automated flight planning systems.

According to one aspect of identifying areas of low observability, therefore, is adaptation to use in automated flight planning algorithms applied to DTED database systems without aid of human perceptive judgement in decision making among route alternatives.

According to another aspect of identifying areas of low observability, the information used to represent the observability of a given data post should be minimal. Because such analysis would typically be applied to a large region of a DTED database, it is most desirable that an indication of observability with respect to each data post be a single scaler value.

Complex terrain representations may be stored for use in association with specific threat installations, justifying further terrain characterization, such as terrain intervisibility with respect to the threat installation. For the vast expanse of terrain lying between the start and end points of a given mission flight path, however, it is impractical to store complex intervisibility representations with respect to all data posts. Thus, an important desirable feature of a method of observability characterization is minimization of data associated with each data post represented, i.e., a single scaler value for each data post.

### SUMMARY OF THE INVENTION

The present invention provides apparatus for calculating an observability value of a given point, said observability value corresponding to the visibility generally of said given point relative to surrounding terrain, the apparatus characterised by means to select a radius extending from said point and defining area corresponding to said surrounding terrain; means to select a set of visit points within said radius relative to said given point; means to calculate visibility between each of said visit points and said given point; and means to calculate observability value magnitude as a function of said calculating visibility step.

The present invention also provides a method of calculating an observability value of a given point, said observability value corresponding to the visibility generally of said given point relative to surrounding terrain, the method characterised by the steps of selecting a radius extending from said point and defining an area corresponding to said surrounding terrain; selecting a set of visit points within said radius relative to said given point; calculating visibility between each of said visit points and said given point; and calculating observability value magnitude as a function of said calculating visibility step.

A method of characterizing observability in accordance with the present invention associates a single scaler value with each data post characterized. The value associated with each data post of interest represents the observability generally of the given data post, or observability generally of a point at a given altitude thereabove. In this regard, the term "observability" is with respect to the surrounding terrain as a whole, not with respect to a specific other data post such as in intervisibility calculations. Because the method can provide a single scaler value, this representation of observability is easily integrated into a DTED database by increasing the depth thereof, i.e., an observability index stored in association with each elevation datum. In this manner, the product of the present invention is obtained by preprocessing a DTED database and storing observability values therein. This preprocessed observability database may then be used in selecting or weighing route alternatives. The method of the present invention further provides improvement in the calculation of observability for each data post so as to support observability calculations dynamically in flight. provides improvement in the calculation of observability for each data post so as to support observability calculations dynamically in flight.

In accordance with a preferred embodiment of the present invention, a line of sight area is defined as all data posts visible with respect to a given data post of interest and within a given radius. A scaler value representing the observability of the given data post is then obtained by executing intervisibility calculations and counting the number of data posts within the specific radius considered "visible" to the given data post. This number may be used directly as a representation of observability, or expressed as a percentage of total data posts within the radius surrounding the data post of interest. In the former case the visibility count would be comparable directly with other visibility counts calculated for the same radius. In the latter case, however, the visibility count expressed as a percentage of the data posts within the given range and considered "visible" is comparable generally to other line of sight area visibility counts, e.g., having a different radius.

An optimized form of the line of sight area calculation under the present invention uses a radial scan pattern relative to the data post of interest. A radial scan pattern traverses a plurality of radials extending a given distance outward from the data post of interest. By using a constant number of radials in this sampling method, a useful approximation of the line of sight area observability characterization for a given data post may be obtained with far fewer visibility calculations. This optimized form of line of sight area calculation, due to its rapid execution time, may be employed dynamically in flight to generate observability characterization of terrain along an unexpected flight path.

The subject matter of the present invention is particularly pointed out and distinctly claimed in the concluding portion of this specification. However, both the organization and method of operation of the invention, together with further advantages and objects thereof, may best be understood by reference to the following description taken with the accompanying drawings wherein like reference characters refer to like elements.

### BRIEF DESCRIPTION OF THE DRAWINGS

For a better understanding of the invention, and to show how the same may be carried into effect, reference will now be made, by way of example, to the accompanying drawings in which:

FIG. 1 illustrates use of a topographic terrain elevation map as a prior art characterization of terrain observability.

FIG. 2 illustrates a line of sight area used in computing a scaler observability value for a given data post in a DTED database.

FIG. 3 illustrates a method of approximating the line of sight area illustrated in FIG 2.

FIG. 4 illustrates a line of sight area transformation of the digital terrain elevation data of FIG. 1 to reveal areas of low observability.

FIG. 5 illustrates a second line of sight area transformation of the data of FIG. 1 to reveal areas of low observability, but with a reduced radius value applied in the computation of observability.

### DETAILED DESCRIPTION OF THE PREFERRED EMBODIMENT

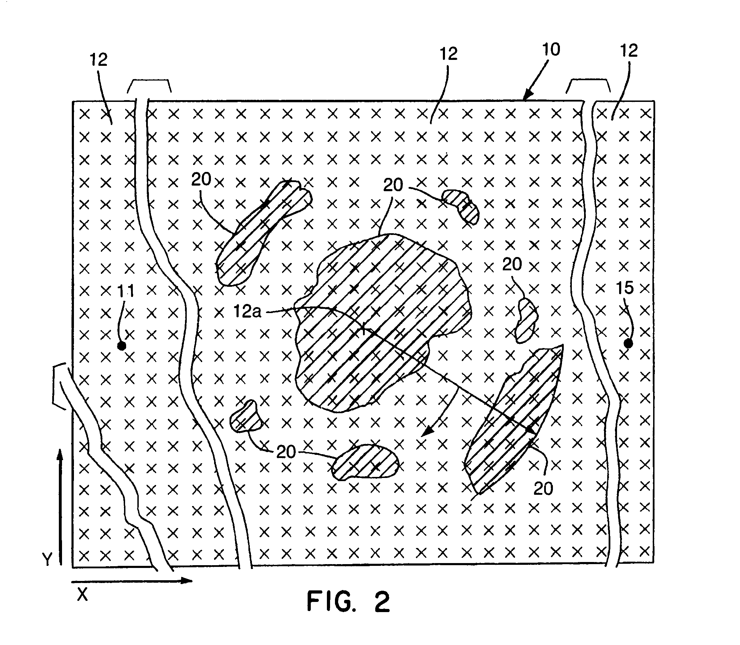

FIG. 2 illustrates a DTED database 10 addressable in X and Y dimensions, e.g., longitude and latitude. DTED database 10 comprises a collection of data posts 12 each uniquely addressable within database 10 and carrying an altitude value associated with each XY address. DTED database 10 represents data posts 12 lying generally along a proposed flight path connecting a point of origin 11 and a point of destination 15. DTED database 10 is referenced in flight planning with respect to points of origin and destination 11 and 15, respectively. Each data post 12 will be characterized with respect to its observability generally relative to surrounding terrain in accordance with the method of the present invention. Under such method, a line of sight area 20, not necessarily a contiguous area, is computed with respect to each data post 12 in database 10 to provide characterization of observability throughout the terrain lying along a flight path connecting points of origin and destination 11 and 15, respectively.

The following discussion will focus on the calculation of observability at a specific data post 12a, but it will be understood that such an observability calculation would be conducted for each data post 12 of database 10 for a complete characterization of the observability of terrain represented by database 10. Accordingly, it will be understood that reference herein to a data post 12, typically data post 12a, as the "data post under observability calculation" refers to observability calculation at a specific one of the data posts 12 in database 10. Furthermore, it will be understood that reference to a data post "visited" in calculating observability shall be with respect to a separate data post 12 of the database 10 analyzed for visibility relative to the data post 12 under observability calculation.

Given a characterization of observability at each data post 12, an automated route selection algorithm may be applied to the database 10. Such a route selection algorithm could be executed as part of a pre-mission flight planning strategy, or executed dynamically while in flight. In either case, such a route selection process might include an optimal search algorithm, i.e., searching for least cost or least observable routes between the point of origin 11 and point of destination 15. Generally, such an optimal search algorithm would start at the point of origin 11 and build a tree structure of potential route selections by creating descendants associated with data posts 12 near point of origin 11. For each such descendent, additional descendants would be constructed according to the data post surrounding that descendent. The tree structure grows until the point of destination 15 is reached. In this manner, a tree structure representing all potential route selections results.

Given the incorporation of single scaler observability values for each post in the database 10, such a tree structure could be evaluated with respect to observability by weighing each potential route according to the sum of observability values of data posts lying along each route. This method thereby provides a quantified observability relationship among data posts 12, and therefore a method of quantifying observability among potential route selections generally. Such observability factors could be then incorporated into overall route selection criteria to select an optimum flight path.

FIG. 2 depicts a line of sight area 20 computed with reference to a particular data post 12a under observability calculation. Line of sight area 20 includes all data posts 12 within a given radius R, and visible with respect to data post 12a. Thus, in computing a complete line of sight area 20 all data posts 12 within the circular region defined by radius R relative to data post 12a under observability calculation are visited and analyzed with respect to visibility relative to data post 12a under observability calculation. The visibility calculation conducted throughout the circular region defined by data post 12a and radius R can take into account certain additional parameters such as visibility with respect to a given elevation above data post 12a under calculation and a given elevation above each data post 12 visited. The line of sight or intervisibility calculation applied could then be taken as being relative to an aircraft located directly above data post 12a, i.e., offset vertically relative to post 12a. This aircraft line of sight area 20 can be thought of as the set of data posts 12 in the database 10 which the aircraft sees at such elevation above data post 12a, and, therefore, those data posts 12 which see the aircraft at that elevation. The line of sight area 20 may be also based on intervisibility between a point at or above data post 12a, as mentioned above, and a point at a given elevation above each data post 12 visited within the given radius R of data post 12a. This vertical offset above each data post 12 visited within the radius R represents a height bias corresponding to the height of an observer, e.g., the height of a radar tower or a person standing at that data post. As may be appreciated, observability of surrounding terrain increases dramatically even for several feet increase from ground level, such as in the height of a person standing at the point of observation, and even more dramatically for an observer or radar station located on a tower structure. In any case, the line of sight area 20 represents intervisibility between post 12a and posts within a given radius of data post 12a.

As may be appreciated, the line of sight area 20 need not be contiguous, typically the line of sight area 20 would be disjoint as shown in FIG. 2 due to particular terrain contour. As an instrument display, the line of sight area 20 could be presented as shown in the view of FIG. 2 with aircraft position maintained in the center portion of the display, i.e., above the post under intervisibility calculation. The size of the line of sight area 20 represents terrain masking experienced by the aircraft a given altitude above a given data post 12. The smaller the area of line of sight area 20, the greater the terrain masking provided in the current aircraft position and altitude. By minimizing the area of line of sight area 20 along a given route, the aircraft terrain masking is maximized. Unfortunately, the computational requirements for dynamically producing the complete area 20, i.e., by visitation and visibility calculation at all data posts 12 within radius R, as a function of current aircraft position and altitude can be prohibitive.

Thus, while the above noted complete line of sight area 20 as depicted in FIG. 2 is a powerful method of characterizing observability for a large number of data posts 12 in a DTED database, the method can be simplified for improved and dynamic computation, yet retain its usefulness. Two assumptions can be made to reduce the computational requirements of the line of sight area 20 while maintaining the inherent advantage of computing a line of sight area 20 for searching for an optimal flight path.

The first assumption in simplifying computation of the line of sight area 20 recognizes that the line of sight area 20 can be taken as substantially independent of elevation above post 12a for the range of 150 feet to 1,000 feet above ground. This allows preprocessing of the database 10 for every data post 12 of interest and assignment of a single observability number for each data post 12, the observability number being a function of the line of sight area 20 computed at that data post 12 for some given above ground level, e.g., 250 feet and a given radius relative thereto.

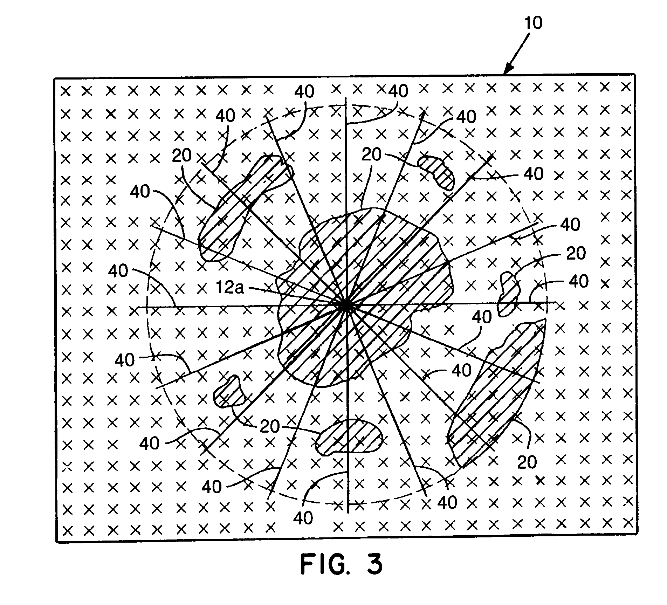

A second assumption simplifying computation of line of sight area 20 proposes use of a radial scan pattern to interrogate the DTED database 10 in the vicinity of data post 12a. This radial scan pattern reduces significantly the number of data posts 12 visited, and therefore the number of visibility calculations performed and execution time required. With reference to FIG. 3, an approximation of a complete line of sight area 20 can be computed by casting a constant number of radials 40 into the DTED database 10. The radials thereby determine which data posts 12 are visited in conducting visibility calculations relative to data post 12a. A single scaler value can then be tallied as the number of data posts 12 encountered in the radial scan pattern and visible from a given altitude above a given data post 12. This visibility count characterizes the observability generally of the data post 12a.

As may be appreciated, the method of observability calculation may be varied with respect to the radius of inquiry surrounding data post 12a, the above ground level elevation for a subject point above the data post 12a, and the above ground level elevation for a view point above each data post 12 visited and tested for visibility with respect to the subject point above the data post 12a.

Each of FIGS. 1, 4 and 5 depict by computer generated output a ground region near Las Vegas, Nevada as taken from a DTED database. The subject region is square and extends approximately 104 nautical miles in each dimension. Reference points 60 and 62 indicate, i.e. at an intersection of a horizontal line through point 60 and a vertical line through line 62, the end of the Grand Canyon. Similarly, points 64 and 66 indicate generally the location of Las Vegas, Nevada.

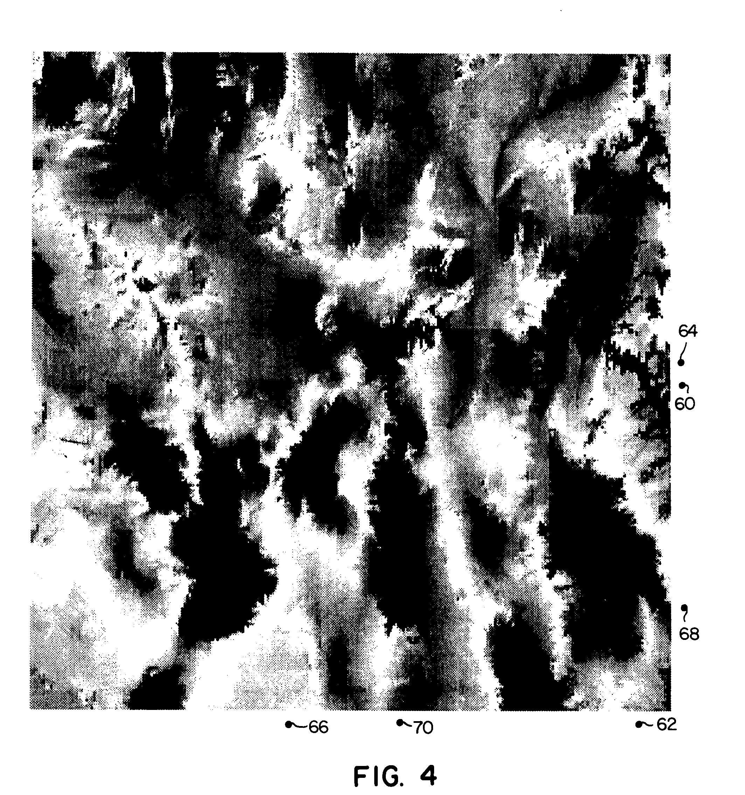

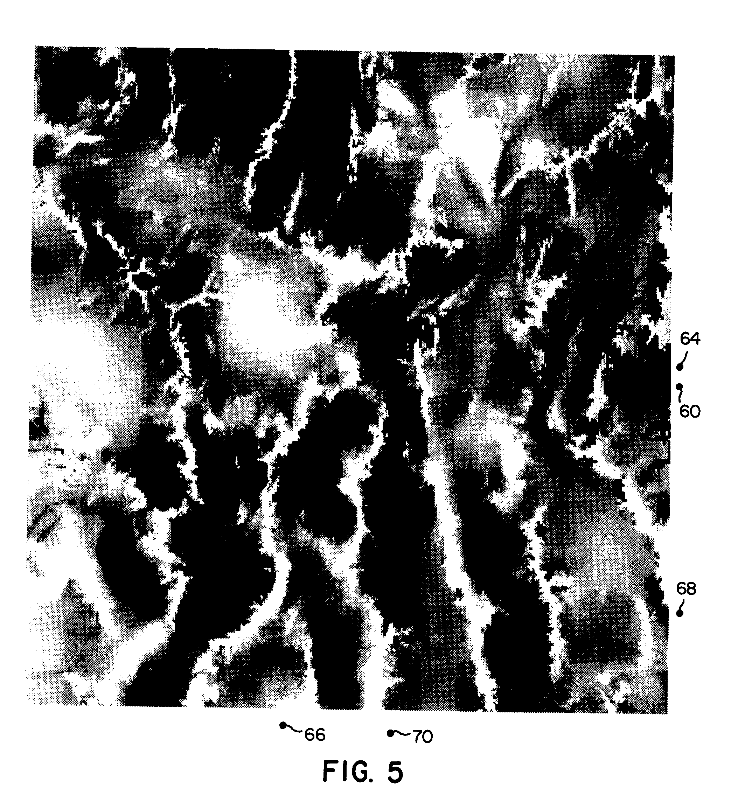

FIG. 1 is simply an elevation contour map where lighter shaded areas are relatively higher elevation. Note the area in FIG. 1 indicated generally by the reference points 68 and 70, an area of relatively higher elevation and, therefore, not a likely candidate as a covert flight path under prior methods of observability calculation. As discussed above, using relative altitude alone, i.e. selecting relatively low altitude areas as areas of relatively lower observability, as a basis for calculating observability fails. FIGS. 4 and 5 illustrate transformation of the DTED data according to the present invention. Darker areas in FIGS. 4 and 5 correspond to areas having, as calculated under the present invention, relatively lower observability with respect to surrounding terrain. Note the area indicated generally by the reference points 68 and 70 in FIGS. 4 and 5 showing a terrain of low observability. Thus, observability calculation under the present invention reveals an unanticipated, relative to prior methods, area of low observability.

FIG. 4 illustrates the case of a 50 nautical mile radius, 500 foot above ground level elevation above the data post 12a under calculation, and a 50 foot above ground elevation for each data post 12 visited. FIG. 5 shows the case of line of sight area 20 transformation of the DTED database using a variation in the radius value used, specifically a smaller radius of 20 nautical miles, a 500 foot above ground level elevation relative to the data post 12a under calculation and a 50 foot above ground level elevation relative to each data post 12 visited. Each of FIGS. 4 and 5 was produced using complete line of sight areas 20 for each data post 12 under observability calculation, i.e., all data posts within the stated radius relative to the data post 12 under observability calculation were visited and a visibility calculation performed relative to the data post 12 under observability calculation.

The reduced radius value in the observability calculation as shown in FIG. 5 produces an interesting result with respect to wide valleys which should be associated, along their center, with areas of high observability. As depicted in FIG. 5, observability characterization under the present invention highlights the generally observable central path along wide valleys, and indicates the shadow or side portions of the wide valleys as being relatively well obscured, i.e., having low observability. Also shown in FIG. 5, the ridge features remain apparent. Thus, a pilot making use of the presentation of FIG. 5 in selecting a route could quickly identify and avoid the ridge features and center portions of wide valleys in seeking a route associated with low observability.

The pilot, using the depiction of FIG. 5, can easily select narrow valleys and the edges of wider valleys to be used in a covert flight route.

The following algorithm indicates generally the method of radial scan observability calculation in accordance with present invention:
FOR EACH DATA POST IN RELEVANT DTED
TRAVERSE N RADIALS OF LENGTH R
FOR EACH DATA POST VISITED
IF VISIBLE (P_{XY}, AGL, Z_{XY})
THEN INC SUM_{XY}
Where the value N represents the number of radials used in the radial scan pattern, the value R represents the radius of the observability calculation, P_{XY} represents the subject point above the data post 12a under observability calculation, AGL represents the designated height above the data post under observability calculation, Z_{XY} represents a data post visited in traversing a radial, and the value SUM_{XY} is the visibility count associated with the data post P_{XY} currently under observability calculation.

As noted above, the AGL value would typically be calculated for some given altitude, eg., 250 feet, and assumed valid for a range of altitude, e.g., between 150 feet and 1,000 feet. Variation in the variable R could be valuable for the advantage of improved observability representation with variation in the radius of the observability calculation.

The above algorithm may be modified to provide a complete line of sight area 20 by increasing the number of radials traversed to the point that sufficient number of radials are visited and a complete visibility calculation performed relative to the data post 12a under calculation. To avoid inaccuracy of the visibility count, it is necessary to track prior visitation of each data post 12. More particularly, under such a radial scan pattern the radials are more dense near the center of the scan pattern and would therefore cause revisitation of certain data posts 12. To avoid incrementing the visibility count for data posts previously visited, it is important to mark each data post in some fashion as being previously visited and when appropriate avoid the visibility calculation and resulting increment in the variable SUM_{XY}.

Variation in the radius R can be a function of the type of terrain of interest, or the type of aircraft to be used. Valley features tend to be sensitive to variation in the radius R while ridgeline features are substantially independent of the radius R. If, for example, wide valley features are an important terrain feature of interest then the radius R can be modified to enhance such features in the resulting transformation of the DTED database. For aircraft having slow ground speed and tight ground tracking capability, e.g., a helicopter, a relatively small radius R can be employed for tactical advantage. A fixed wing aircraft having greater ground speed and wider ground tracking capability, however, may require a relatively larger radius R to better match its flight capability.

The method of the present invention can be used to preprocess a DTED database to generate a plurality of separate observability databases, each being generated as a function of variation in the parameters applied to the transformation function. Such preprocessed observability databases may then be referenced in flight planning procedures to match a specific mission plan, i.e., terrain features of interest or specific aircraft proposed. For example, where local hideability is desired and a helicopter is proposed as the mission aircraft, a small radius R will emphasize local hideability in the observability transformation. To highlight a broader range of hideability, a larger radius R provides an appropriate measure of hideability for large scale missions, i.e., fixed wing aircraft flying at relatively greater speeds.

Thus, an improved method of observability calculation has been shown and described. The observability calculation may be executed against a DTED database to augment the database for use later in route selection algorithms. Thus, the product of the present invention can be a preprocessed DTED observability database. The observability calculation under the present invention makes apparent which areas of the earth's surface offer more terrain masking generally than other areas. Local areas of high observability, and therefore low terrain masking, such as ridge lines, centers of wide valleys, planes, and savannas, are easily distinguished from areas of low observability, and therefore high terrain masking. The calculation of observability under the present invention is independent of the terrain's actual elevation.

This invention has been described herein in considerable detail in order to comply with the Patent Statutes and to provide those skilled in the art with the information needed to apply the novel principles and to construct and use such specialized components as are required. However, it is to be understood that the invention is not restricted to the particular embodiment that has been described and illustrated, but can be carried out by specifically different equipment and devices, and that various modifications, both as to the equipment details and operating procedures, can be accomplished without departing from the scope of the invention itself.

## Claims

1. Apparatus for calculating an observability value of a given point, said observability value corresponding to the visibility generally of said given point relative to surrounding terrain, the apparatus characterised by:
means to select a radius extending from said point and defining area corresponding to said surrounding terrain;
means to select a set of visit points within said radius relative to said given point;
means to calculate visibility between each of said visit points and said given point; and
means to calculate observability value magnitude as a function of said calculating visibility step.

2. Apparatus according to Claim 1 or 2 characterised in that the means to calculate visibility classifies each visit point as being visible or not visible relative to said given point.

3. Apparatus according to claim 1 or 2 characterised in that the means to calculate observability value magnitude comprises means to sum the number of visit point classified as being visible relative to said given point.

4. Apparatus according to any preceding Claim characterised by means to calculate an observability value for a set of points as a measure of relative observability among said set of points.

5. Apparatus according to Claim 4 characterised in that said set of points are represented by a set of digital terrain elevation posts and each calculated observability value is stored in association with a corresponding data post.

6. A method of calculating an observability value of a given point, said observability value corresponding to the visibility generally of said given point relative to surrounding terrain, the method characterised by the steps of:
selecting a radius extending from said point and defining an area corresponding to said surrounding terrain;
selecting a set of visit points within said radius relative to said given point;
calculating visibility between each of said visit points and said given point; and
calculating observability value magnitude as a function of said calculating visibility step.

7. A method according to Claim 6 characterised in that said calculating visibility step classifies each visit point as being visible or not visible relative to said given point.

8. A method according to Claim 6 or 7 characterised in that said calculating observability value magnitude comprises summing the number of visit point classified as being visible relative to said given point.

9. A method according to any of Claims 6 to 8 characterised by calculating an observability value for a set of points as a measure of relative observability among said set of points.

10. A method according to Claim 9 characterised in that said set of points are represented by a set of digital terrain elevation posts and each calculated observability value is stored in association with a corresponding data post.
